(19) Europäisches Patentamt / European Patent Office / Office européen des brevets

(11) **EP 4 722 746 A1**

(12) **EUROPEAN PATENT APPLICATION**
published in accordance with Art. 153(4) EPC

(43) Date of publication:
08.04.2026 Bulletin 2026/15

(21) Application number: 24814893.4

(22) Date of filing: 27.02.2024

(51) International Patent Classification (IPC):
$G01R\ 31/392$ (2019.01)    $G01R\ 31/367$ (2019.01)
$G01R\ 31/389$ (2019.01)    $H01M\ 10/42$ (2006.01)
$H01M\ 10/48$ (2006.01)    $H02J\ 7/00$ (2026.01)

(52) Cooperative Patent Classification (CPC):
Y02E 60/10

(86) International application number:
PCT/JP2024/006941

(87) International publication number:
WO 2024/247406 (05.12.2024 Gazette 2024/49)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 02.06.2023 JP 2023091458

(71) Applicant: HITACHI HIGH-TECH CORPORATION
Tokyo 105-6409 (JP)

(72) Inventors:
• KONISHI, Hiroaki
  Tokyo 100-8280 (JP)
• INOUE, Takeshi
  Tokyo 100-8280 (JP)
• UEDA, Suguru
  Tokyo 100-8280 (JP)
• HORIKOSHI, Nobuya
  Tokyo 105-6409 (JP)
• YONEMOTO, Masahiro
  Tokyo 105-6409 (JP)
• MOCHIZUKI, Masahito
  Tokyo 105-6409 (JP)
• SUMIKAWA, Yosuke
  Tokyo 105-6409 (JP)

(74) Representative: MERH-IP Matias Erny Reichl Hoffmann
Patentanwälte PartG mbB
Paul-Heyse-Straße 29
80336 München (DE)

(54) **BATTERY STATE DIAGNOSIS METHOD, BATTERY DIAGNOSIS DEVICE, AND BATTERY DIAGNOSIS SYSTEM**

(57) A battery state diagnosis method and a battery state diagnosis device are provided, which achieve a highly accurate battery capacity deterioration diagnosis when a diagnosis target is a battery system, such as a battery system using a $LiFePO_4$-based active material for the positive electrode, that exhibits little voltage change in response to a change in the state-of-charge. A battery state diagnosis method is for diagnosing a deterioration state of a secondary battery mounted on equipment, and includes: a data acquisition step of acquiring pieces of data about a voltage, a current, and a temperature of the secondary battery from the equipment in operation; a table creation step of creating, based on the acquired pieces of data, a table including a state of health capacity and a state of health resistance of the secondary battery; and a diagnosis step of diagnosing, using the created table, a deterioration state of the secondary battery.

EP 4 722 746 A1

# *FIG. 1*

BATTERY DIAGNOSIS SYSTEM 100

EV1 (CHARGING)    EV2 (STATIONARY)    EV3 (TRAVELING)

D1    D2    D3

1

BATTERY DIAGNOSIS DEVICE

11 — RECEPTION UNIT

12 — PARAMETER COMPUTATION UNIT

13 — RECORDING UNIT

TABLE T1
TABLE T2
TABLE T3
TABLE T4

DIAGNOSIS UNIT — 14

BATTERY DETERIORATION STATE

DISPLAY DEVICE — 2

## Description

Technical Field

The present invention relates to a method for estimating a state of health of a storage battery, a battery state diagnosis method, a battery diagnosis device, and a battery diagnosis system.

Background Art

A lithium secondary battery, which is a type of storage battery, is used as a power source for equipment of varying sizes from large-sized ones, such as electric vehicles, to small-sized ones, such as portable devices. When the lithium secondary battery is repeatedly used, energy that can be extracted from the battery gradually decreases. For this reason, a diagnosis technique is required for diagnosing a state of health of the battery. In particular, in an electric vehicle, an energy capacity of a battery pack that powers a drive motor is closely related to a range, and thus, a technique is required for accurately grasping a state of health of the battery pack.

PTL 1 is known as a technique for estimating a state of health of a storage battery. For example, the abstract of PTL 1 discloses "A method for diagnosing a battery pack having a configuration in which a plurality of cells are connected in series uses a system for obtaining detected data including the current and temperature of the battery pack and the voltage of each cell, and includes a step of calculating an electric charge capacity and a SOC of each cell, using the current and the temperature, the voltage of each cell, an OCV-SOC function, and a resistance table, and calculating an amount of unbalance, which is an estimated value of the SOC, and a resistance of each cell when the battery pack is fully charged, and a step of calculating an energy capacity of the battery pack using the electric charge capacity, the amount of unbalance, and the resistance. As a result, the energy capacity of the battery pack can be calculated accurately, even in an unbalanced state".

Citation List

Patent Literature

PTL 1: WO 2022/024885 A1

Summary of Invention

Technical Problem

Conventional lithium secondary batteries have mainly adopted a battery system using a $Li(Ni, Mn, Co)O_2$-based active material for a positive electrode and a graphite-based active material for a negative electrode. This battery system exhibits large voltage changes in response to a change in a state-of-charge, and thus, the diagnosis technique, disclosed in PTL 1, using such properties for battery deterioration diagnosis has been effective.

On the other hand, in recent years, a battery system using a $LiFePO_4$-based active material for the positive electrode has been gaining market share. Unlike the aforementioned battery system, this battery system exhibits small voltage changes in response to a change in the state-of-charge, and thus, the battery deterioration diagnosis using the technique disclosed in PTL 1 has not been able to be performed.

Thus, the present invention aims to provide a battery state diagnosis method, which achieves a highly accurate battery capacity deterioration diagnosis when a diagnosis target is a battery system, such as a battery system using a $LiFePO_4$-based active material for a positive electrode, that exhibits little voltage change in response to a change in a state-of-charge.

Solution to Problem

A battery state diagnosis method is for diagnosing a deterioration state of a secondary battery mounted on equipment, and includes: a data acquisition step of acquiring pieces of data about a voltage, a current, and a temperature of the secondary battery from the equipment in operation; a table creation step of creating, based on the acquired pieces of data, a table including a state of health capacity and a state of health resistance of the secondary battery; and a diagnosis step of diagnosing, using the created table, a deterioration state of the secondary battery.

Advantageous Effects of Invention

According to the present invention, it is possible to enable the highly accurate battery capacity deterioration diagnosis even when a diagnosis target is a battery system that exhibits little voltage change in response to a change in a state-of-charge.

Brief Description of Drawings

[FIG. 1] FIG. 1 is a schematic configuration diagram illustrating a battery diagnosis system according to an embodiment.
[FIG. 2] FIG. 2 illustrates an example of data D received from a vehicle.
[FIG. 3A] FIG. 3A illustrates an example of a table including a state-of-charge and an open circuit voltage of a secondary battery.
[FIG. 3B] FIG. 3B illustrates an example of a table including the state-of-charge and a resistance of the secondary battery.
[FIG. 3C] FIG. 3C illustrates an example of a table including a temperature and a temperature conversion coefficient of a resistance of the secondary battery.
[FIG. 3D] FIG. 3D illustrates an example of a table including a state of health capacity and a state of health resistance of the secondary battery.
[FIG. 4] FIG. 4 is a flowchart for creating the table of FIG. 3A.
[FIG. 5] FIG. 5 is a flowchart for creating tables of FIGS. 3B and 3C.
[FIG. 6] FIG. 6 is a flowchart for creating the table in FIG. 3D.
[FIG. 7] FIG. 7 is a flowchart for diagnosing a deterioration state of the secondary battery using each table.

Description of Embodiments

Hereinafter, a battery state diagnosis method according to the present invention will be described using, as an example, a situation where data of a battery pack mounted on an electric vehicle EV is transmitted to a server and an energy capacity of the battery pack is diagnosed by the server. Note that the present invention is not limited to the following embodiment and includes various modifications and application examples, which are within the technical concept of the present disclosure, within its scope. For example, the battery state diagnosis method according to the present invention can be applied to diagnosis of deterioration states of various batteries such as batteries for home energy management systems (HEMS), building energy management systems (BEMS), factory energy management systems (FEMS), railroads, or construction machinery.

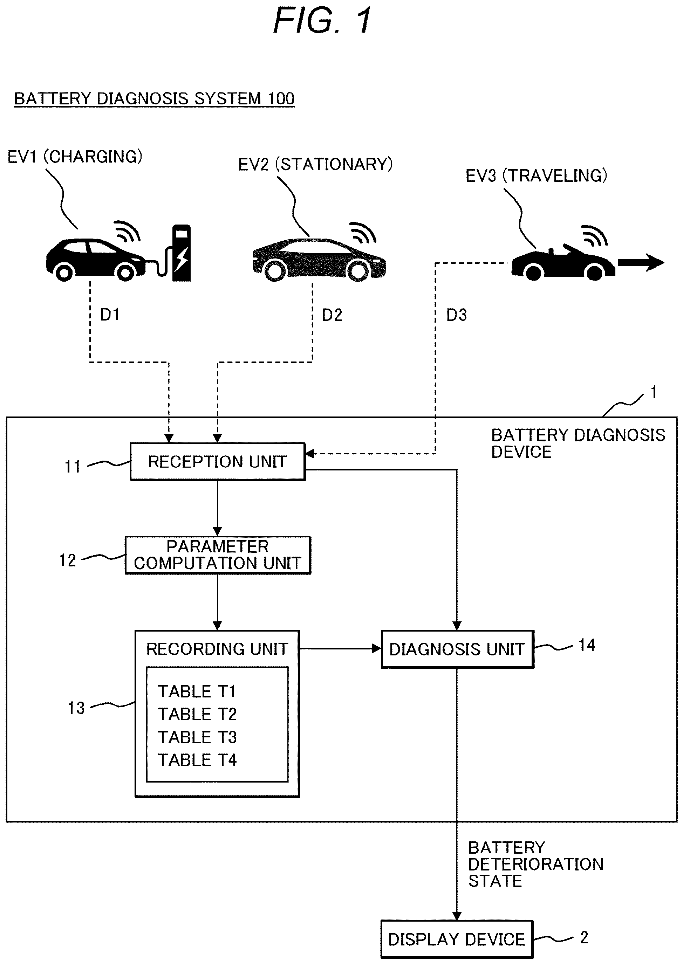

FIG. 1 is a schematic configuration diagram illustrating a battery diagnosis system 100 according to an embodiment of the present invention. The battery diagnosis system 100 is a system including a battery diagnosis device 1 and a notification device 2. The battery diagnosis device 1 is communicably connected to electric vehicles EV in operation through a public wireless communication network such as a mobile phone communication network. The notification device 2 notifies a customer of a diagnosis result from the battery diagnosis device 1, and is, for example, a liquid crystal display. Note that, although FIG. 1 illustrates a situation where data D1 from an electric vehicle EV1 that is in process of charging, data D2 from an electric vehicle EV2 that is stationary, and data D3 from an electric vehicle EV3 that is traveling are transmitted to the battery diagnosis device 1, data D from another electric vehicle EV in operation may also be transmitted to the battery diagnosis device 1. It is assumed that the respective electric vehicles each have mounted thereon a battery pack using a LiFePO$_4$-based active material for a positive electrode of cells.

As illustrated in FIG. 1, the battery diagnosis device 1 according to the present embodiment includes a reception unit 11, a parameter computation unit 12, a storage unit 13, and a diagnosis unit 14. The reception unit 11 receives, from the electric vehicles EV, data D related to vehicles and batteries. The parameter computation unit 12 creates, based on the data D, a parameter group necessary for a battery deterioration diagnosis. The storage unit 13 stores the created parameter group in a table format. The diagnosis unit 14 diagnoses, using the data D and each table, a battery deterioration state. Note that the battery diagnosis device 1 is a so-called server including a computation device such as a central processing unit (CPU), a main storage device such as a semiconductor memory, an auxiliary storage device such as a hard disk, and hardware such as a communication device. The computation device executes a predetermined program to implement the above-described parameter computation unit 12 and the like. Details of each unit will be described below while appropriately omitting such a well-known technique.

<Details of reception unit 11>

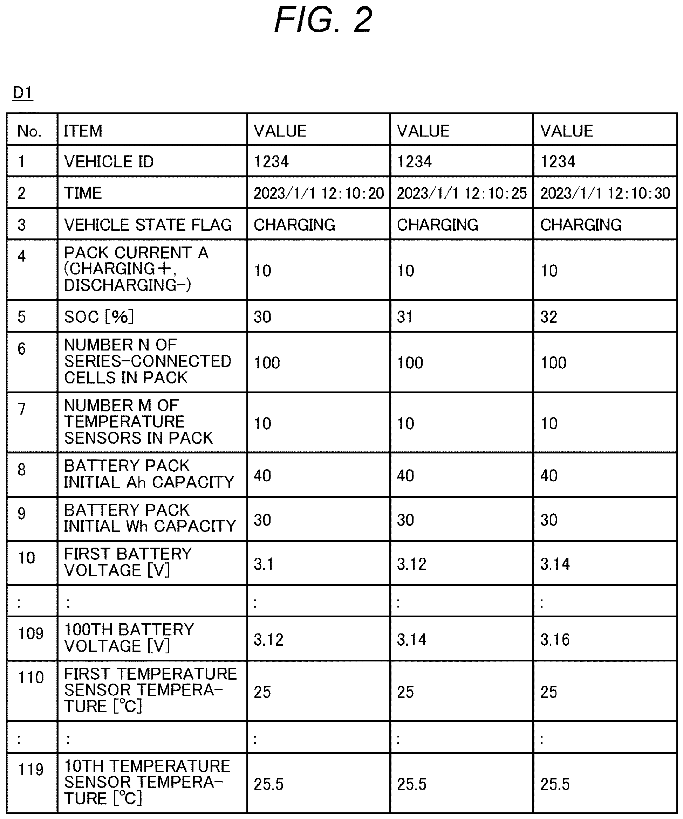

FIG. 2 illustrates, as an example of the data D received by the reception unit 11, the data D1 received from the electric vehicle EV1 that is in process of charging. Note that, although the data D1 is illustrated here in which data values corresponding to three columns are registered for data in each of rows from No. 1 to No. 119, the number of rows and the number of columns of the data D are not limited to this example. Hereinafter, details of the data values in each row for the data D will be sequentially described.

The data values of No. 1 each indicate an identification ID of the electric vehicle EV that has transmitted the data D.

The data values of No. 2 each indicate the time when the electric vehicle EV has measured the current, the voltage, and the temperature of the battery pack. Thus, the respective data columns in FIG. 2 are data columns including pieces of data measured at respective times of Jan. 1, 2023 12:10:20, Jan. 1, 2023 12:10:25, and Jan. 1, 2023 12:10:30.

The data values of No. 3 each indicate a flag indicating the state of the electric vehicle EV. This flag indicates, for example, "charging", "stationary", "traveling", or the like, and a flag of "charging" is registered in the latest data column of the data D1 from the electric vehicle EV1. Additionally, a flag of "stationary" is registered in the latest data column of the data D2 from the electric vehicle EV2, and a flag of "traveling" is registered in the latest data column of the data D3 from the electric vehicle EV3.

The data values of No. 4 each indicate an input or output current value of the battery pack measured at each time in No. 2. Here, charging is represented by "+" and discharging is represented by "-". Thus, the data D1 in FIG. 2 indicates that the battery pack of the electric vehicle EV is being charged with 10 A.

The data values of No. 5 each indicate a state of charge (SOC) of the battery pack of the electric vehicle EV. Thus, the data D1 in FIG. 2 indicates a state where the SOC gradually increases from 30% with a lapse of time.

The data values of No. 6 each indicate the number N of series-connected cells in the battery pack of the electric vehicle EV1. In this example, the number N of series-connected cells is 100.

The data values of No. 7 each indicate the number M of temperature sensors in the battery pack of the electric vehicle EV1. In this example, the number M of temperature sensors is 10.

The data values of No. 8 each indicate a value of an initial Ah capacity of the battery pack. This value is calculated by the cell initial Ah capacity $\times$ the number L of parallel-connected cells. In this example, the initial Ah capacity is 40 Ah.

The data values of No. 9 each indicate a value of an initial energy capacity of the battery pack of the electric vehicle EV1. This value is calculated by the cell initial energy capacity $\times$ the number N of series-connected cells $\times$ the number L of parallel-connected cells. In this example, the initial energy capacity is 30 Wh.

The data values of No. 10 to No. 109 indicate respective voltages of first to hundredth batteries of the battery pack, respectively. Note that each battery is a battery including the number L of parallel-connected cells.

The data values of No. 110 to No. 119 indicate the respective temperatures detected by first to tenth temperature sensors, respectively.

Note that the data D may be data having no data rows (No. 6 to No. 9) related to the specification of the battery pack. In this case, it is sufficient that the specification of the battery pack be registered in advance in the storage unit 13 of the battery diagnosis device 1.

<Details of parameter computation unit 12>

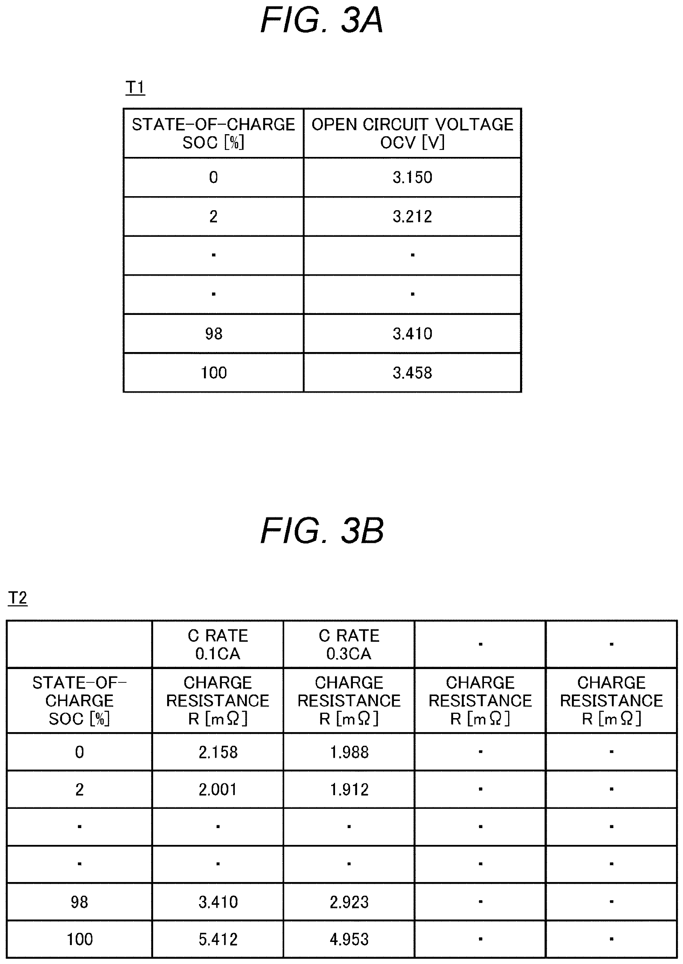

Next, with reference to FIGS. 3A to 3D and FIGS. 4 to 6, a description will be given of a method of computing, by the parameter computation unit 12, various parameters, and a method of creating, by the parameter computation unit 12, four tables T1 to T4 necessary for diagnosing the battery deterioration state.

<<First table T1>>

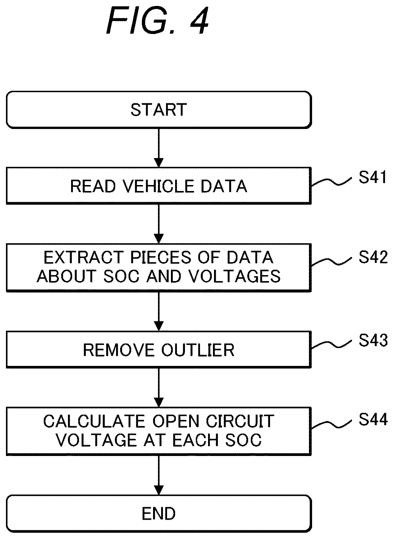

FIG. 3A illustrates an example of the first table T1 composed of a parameter group including a state of charge SOC and an open circuit voltage (OCV) of the battery pack. FIG. 4 illustrates an example of a flowchart for creating the first table T1 illustrated in FIG. 3A. Hereinafter, each step in FIG. 4 will be described in sequence.

Step S41: The parameter computation unit 12 reads the data D (see FIG. 2) received by the reception unit 11.

Step S42: The parameter computation unit 12 extracts, from the read data D, data of No. 5 (SOC) and pieces of data of No. 10 to No. 109 (voltages of the first to hundredth batteries) in a data column in which No. 3 (vehicle state flag) indicates "stationary". Thus, when there are a plurality of data columns in which the vehicle state flag indicates "stationary", the parameter computation unit 12 can extract, for each of SOCs in the data columns, pieces of data about voltages of the first to hundredth batteries.

Step S43: The parameter computation unit 12 removes, from the pieces of data about the voltages extracted in step S42, data about a voltage determined to be an outlier. For the determination of the outlier, the Smirnov-Grubbs' test (Hiroshi Takeuchi et al., "Statistics Dictionary", Toyo Keizai Inc.) or Dixon's test method (G. K. Kanji "Reverse Statistics", Kodansha Aug. 20, 2015, 3rd edition) or the like can be used.

Step S44: The parameter computation unit 12 averages the voltages at each SOC, and sets an averaged voltage as the OCV at each SOC. Note that a SOC range in which no data is obtained in step S42 is interpolated by a spline or piecewise linear, thus creating a parameter group including the SOC and the OCV. Then, the parameter computation unit 12 stores, as the first table T1, a parameter group $OCV_{map}(SOC)$ in the storage unit 13.

Note that the pieces of data about the SOC and the voltages used at the time of creating the present table are not necessarily pieces of data extracted from the data D of one electric vehicle EV, and the present table may be created by using in combination the data D received from another electric vehicle having mounted thereon a battery pack of the same specification.

<<Second table T2 and third table T3>>

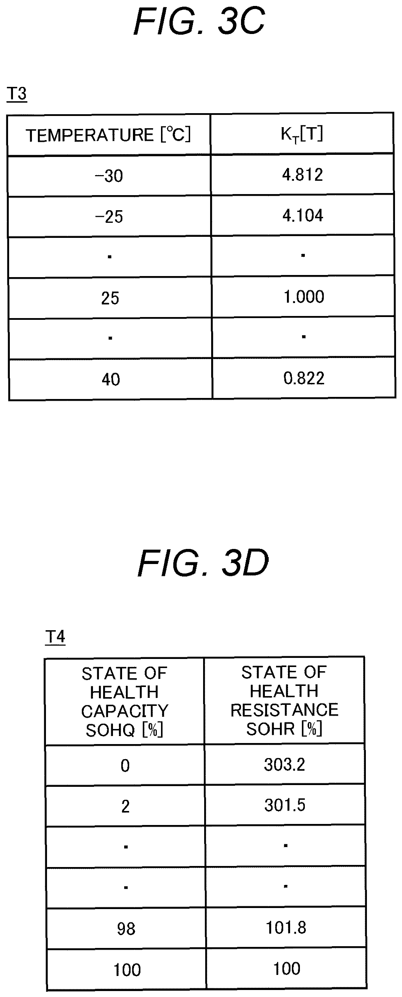

FIG. 3B illustrates an example of the second table T2 composed of a parameter group including the state of charge SOC and a charge resistance R at each C rate used for charging the battery pack. FIG. 3C illustrates an example of the third table T3 composed of a parameter group including a temperature conversion coefficient $K_T$ of the resistance at each temperature of the battery pack.

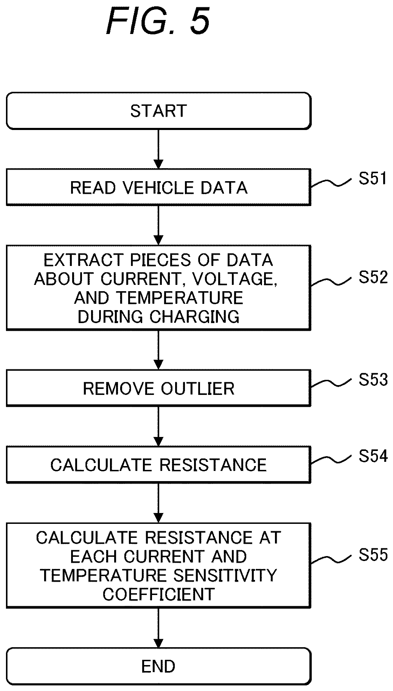

FIG. 5 illustrates an example of a flowchart for creating the second table T2 illustrated in FIG. 3B and the third table T3 illustrated in FIG. 3C. Hereinafter, each step in FIG. 5 will be described in sequence.

Step S51: The parameter computation unit 12 reads the data D (see FIG. 2) received by the reception unit 11.

Step S52: The parameter computation unit 12 extracts, from the read data D, data of No. 4 (pack current), pieces of data of No. 10 to No. 109 (voltages of the first to hundredth batteries), and pieces of data of No. 110 to No. 119 (temperatures measured by the first to tenth temperature sensors) in a data column in which No. 3 (vehicle state flag) indicates "charging".

Step S53: The parameter computation unit 12 removes, from the pieces of data extracted in step S52, data determined to be an outlier. The determination of the outlier is performed using the method as illustrated in step S43.

Step S54: The parameter computation unit 12 calculates the charge resistance R at each SOC by using the following formula.

Charge resistance R = (voltage V - OCV (each SOC)) ÷ charge current I

Step S55: The parameter computation unit 12 calculates the resistance converted at 25°C at each current and the temperature conversion coefficient $K_T$ by using the following formula, based on the pieces of data about the charge resistance R at each SOC, the current I, and the temperature T. Here, the temperature conversion coefficient $K_T$ indicates a ratio of the resistance at the battery temperature (T) to the resistance at the reference temperature (25°C). (Temperature conversion coefficient $K_T$ at 25°C is 1).

Examples of each current (C rate (CA)) include currents corresponding to 0.1 CA, 0.3 CA, 0.5 CA, and 1.0 CA. Here, the C rate (CA) is a value obtained by dividing the current value I by an initial Ah capacity $Q_{rated}$ of the battery pack.

The parameter computation unit 12 creates a parameter group $R_{charge,map}(SOC,C_{rate})$ including the SOC and the charge resistance R at each current (CA) obtained by the following formula, and stores, as the second table T2, the parameter group $R_{charge,map}(SOC,C_{rate})$ in the storage unit 13. Additionally, the parameter computation unit 12 creates a parameter group $K_{T,map}(T)$ including the temperature and the temperature conversion coefficient $K_T$ of the resistance, and stores, as a third table T3, the parameter group $K_{T,map}(T)$ in the storage unit 13. Note that C and $I_0$ are any constants.

Charge resistance R = C $\times$ exp $[K_T/(T+273.15) - K_T/(25+273.15)] \times$ asinh$(I/2I_0)/I$

<<Fourth table T4>>

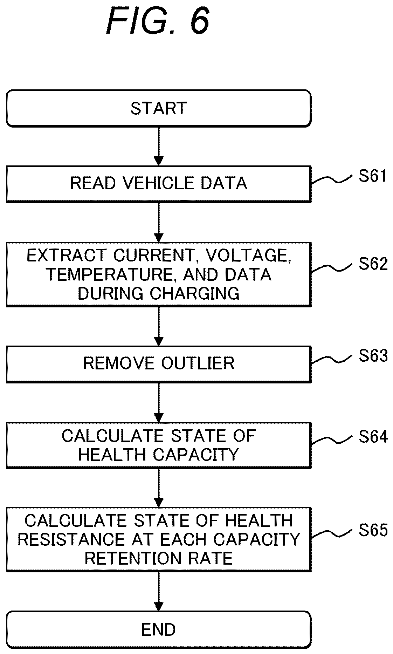

FIG. 3D illustrates an example of the fourth table T4 composed of a parameter group including a state of health capacity SOHQ and a state of health resistance SOHR of the battery pack. FIG. 6 illustrates an example of a flowchart for creating the fourth table T4 illustrated in FIG. 3D. Hereinafter, each step in FIG. 6 will be described in sequence.

Step S61: The parameter computation unit 12 reads the data D (see FIG. 2) received by the reception unit 11.

Step S62: The parameter computation unit 12 extracts, from the read data D, data of No. 4 (pack current), pieces of data of No. 10 to No. 109 (voltages of the first to hundredth batteries), and pieces of data of No. 110 to No. 119 (temperatures measured by the first to tenth temperature sensors) in a data column in which No. 3 (vehicle state flag) indicates "charging".

Note that in this step, all the charge data may be extracted, but more preferably, thresholds are set for a start SOC and an end SOC in the charge data to be used, and only specific charge data is used. As the threshold for the start SOC, within a range of the state of charge of 0 to 40%, it is preferable to include a low state of charge region in which a change in the open circuit voltage with respect to the state of charge is larger, and thus, as the condition, the state of charge is set at which a change in the open circuit voltage with respect to the state of charge is smallest, and data below that value is used.

For the end SOC, it is preferable to include a region where a large change is observed in the relationship of the open circuit voltage with respect to the state of charge. This region is a region having a state of charge of greater than or equal to 90% or a voltage of greater than or equal to 3.5 V.

The state of charge illustrated here is obtained using the start voltage and the end voltage of the charge data in comparison with FIG. 3A.

Step S63: The parameter computation unit 12 removes, from the pieces of data extracted in step S62, data determined to be an outlier. The determination of the outlier is performed using the method as illustrated in S43.

Step S64: The parameter computation unit 12 calculates, based on the extracted data, the state of health capacity SOHQ at the time of acquiring each piece of charge data by using the following formula.

SOHQ = [fIdt ÷ (charge end SOC - charge start SOC) × 100] ÷ cell initial Ah capacity × 100

Step S65: The parameter computation unit 12 creates a parameter group including the SOHQ and the SOHR. Specifically, for a plurality of charging processes, an approximate curve of the charge resistance R calculated in step S54 and the SOHQ is plotted, and the charge resistance R at a time point when SOHQ=100 is calculated using an approximate expression. Examples of a shape represented by the approximate expression include a linear shape and an exponential shape.

For example, the SOHR is calculated according to the following formula: SOHR=the charge resistance calculated in S54 ÷ the charge resistance at the time point of SOHQ of 100.

According to the above procedure, the parameter computation unit 12 plots an approximate curve between the SOHQ and the SOHR, creates a parameter group SOHQ$_{map}$(SOHR) including the SOHQ and the SOHR, and stores, as the fourth table T4, the parameter group SOHQ$_{map}$(SOHR) in the storage unit 13.

<Details of diagnosis unit 14>

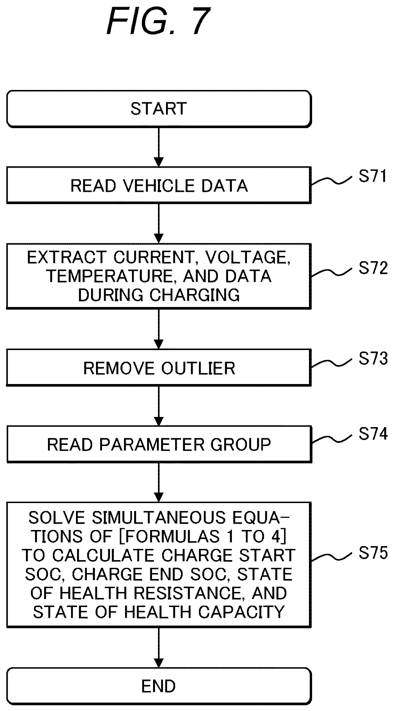

Next, with reference to the flowchart in FIG. 7, a description will be given of a step of diagnosing, by the diagnosis unit 14, battery deterioration using each table stored in the storage unit 13 and the data D received by the reception unit 11.

Step S71: The diagnosis unit 14 reads the data D (see FIG. 2) received by the reception unit 11.

Step S72: The diagnosis unit 14 extracts, from the read data D, data of No. 4 (pack current), pieces of data of No. 10 to No. 109 (voltages of the first to hundredth batteries), and pieces of data of No. 110 to No. 119 (temperatures measured by the first to tenth temperature sensors) in a data column in which No. 3 (vehicle state flag) indicates "charging".

Step S73: The diagnosis unit 14 removes, from the pieces of data extracted in step S72, data determined to be an outlier. The determination of the outlier is performed using the method as illustrated in S43.

Step S74: The diagnosis unit 14 reads the tables T1 to T4 stored in the storage unit 13.

Step S75: The diagnosis unit 14 obtains the SOHQ based on each table read in step S74. Specifically, the diagnosis unit 14 solves simultaneous equations of Formulas 1 to 4 below to compute the SOHQ.

[Formula 1]

$$SOHR = \frac{\dfrac{CCV_{\mathrm{start}} - OCV_{\mathrm{map}}(SOC_{\mathrm{start}})}{C_{\mathrm{rate,start}} \times Q_{\mathrm{rated}}}}{R_{\mathrm{charge,map}}(SOC_{\mathrm{start}}, I_{\mathrm{start}}) \times K_{T,\mathrm{map}}(T_{\mathrm{start}})} \qquad \cdots \text{ Formula 1}$$

[Formula 2]

$$SOHR = \frac{\dfrac{CCV_{\mathrm{end}} - OCV_{\mathrm{map}}(SOC_{\mathrm{end}})}{C_{\mathrm{rate,end}} \times Q_{\mathrm{rated}}}}{R_{\mathrm{charge,map}}(SOC_{\mathrm{end}}, C_{\mathrm{rate,end}}) \times K_{T,\mathrm{map}}(T_{\mathrm{end}})} \qquad \cdots \text{ Formula 2}$$

[Formula 3]

$$SOC_{end} = SOC_{start} + \frac{\int_{t_{start}}^{t_{end}} I \cdot dt}{Q_{rated} \times SOHQ} \qquad \cdots \text{Formula 3}$$

[Formula 4]

$$SOHQ = SOHQ_{map}(SOHR) \qquad \cdots \text{Formula 4}$$

Formula 1 is a formula for obtaining the SOHR at a charging start time point using the current, voltage, and temperature at the charging start time point, as well as the first table $T1=OCV_{map}(SOC)$, the second table $T2=R_{charge,map}(SOC,C_{rate})$, and the third table $T3=K_{T,map}(T)$.

Note that the numerator on the right side of Formula 1 calculates an actual resistance value, and the denominator on the right side of Formula 1 calculates a reference resistance value in an undeteriorated battery. $CCV_{start}$ indicates a closed circuit voltage CCV at the charging start time point. $OCV_{map}(SOC_{start})$ indicates an OCV (see $OCV_{map}(SOC)$ parameter group) at the SOC at the charging start time point. $I_{start}$ indicates a current at the charging start time point. However, a charging-start state of charge $SOC_{start}$ is an unknown value at the charging start time point. A charging-start charge rate $C_{rate,start}$ indicates a charge rate at the charging start time point. $Q_{rated}$ indicates a battery capacity (e.g., initial Ah capacity) to be a reference of SOHQ=100%. A reference resistance value $R_{charge,map}(SOC,C_{rate,start})$ indicates a charge resistance R at a reference temperature when the battery has not yet deteriorated, and is a value corresponding to the charging-start charge rate $C_{rate,start}$. A charging-start temperature $T_{start}$ is a battery temperature T at the charging start time point. A temperature conversion coefficient $K_{T,map}(T_{start})$ is a temperature conversion coefficient obtained using the aforementioned parameter group including the temperature and the temperature conversion coefficient $K_T$.

Formula 2 is a formula for obtaining the SOHR at a charging end time point using the current, voltage, and temperature at the charging end time point, as well as the first table $T1=OCV_{map}(SOC)$, the second table $T2=R_{charge,map}(SOC,C_{rate})$, and the third table $T3=K_{T,map}(T)$.

Note that the numerator on the right side of Formula 2 calculates an actual resistance value at the charging end time point, and the denominator on the right side of Formula 2 calculates a reference resistance value in an undeteriorated battery at the charging end time point. $CCV_{end}$, $SOC_{end}$, $C_{rate,end}$, and $T_{end}$ respectively indicate a closed circuit voltage, a state of charge, a charge rate, and a battery temperature at the charging end time point. Among them, $SOC_{end}$ is an unknown variable.

Formula 3 is a formula for obtaining a charging-end state of charge $SOC_{end}$ using $SOC_{start}$ at the charging start time point and the SOHQ.

Note that, in the second term on the right side of Formula 3, $t_{start}$ indicates a time at the charging start time point and $t_{end}$ indicates a time at the charging end time point, and an integration result of the current between these two times is referred to as a charged electricity amount.

Formula 4 is a formula for obtaining the SOHQ using the SOHR and the fourth table $T4=SOHQ_{map}(SOHR)$ parameter group. The fourth table tabulates a relationship between resistance and capacity that can be calculated at all times and uses the relationship for state diagnosis, thereby enabling a battery state diagnosis even in a battery system in which the SOHQ cannot be frequently calculated from vehicle data.

In order to obtain four unknowns ($SOC_{start}$, $SOC_{end}$, SOHR, SOHQ) in Formulas 1 to 4, simultaneous equations of Formulas 1 to 4 are numerically solved. The state of health capacity SOHQ obtained in this manner is output as information indicating a battery deterioration state. The notification of the SOHQ output from the battery diagnosis device 1 is provided to the customer via the notification devices 2 included in the individual electric vehicles EV, the notification devices 2 installed in management centers that manage the plurality of electric vehicles EV, or the like, thus enabling sequential grasping of the deterioration state of the storage battery.

<Effects of the present embodiment>

According to the present embodiment described above, it is possible to enable the highly accurate battery capacity deterioration diagnosis when a diagnosis target is a battery system, such as a battery system using a LiFePO$_4$-based active material for the positive electrode, that exhibits little voltage change in response to a change in the state-of-charge.

Additionally, according to the present embodiment, various tables necessary for the battery deterioration diagnosis can be automatically created based on the data acquired from the electric vehicles in operation, and since data collection work solely for creating the various tables is not required, the battery deterioration diagnosis work can be simplified.

Reference Signs List

| | |
|---|---|
| EV | electric vehicle |
| 100 | battery diagnosis system |
| 1 | battery diagnosis device |
| 11 | reception unit |
| 12 | parameter computation unit |
| 13 | storage unit |
| 14 | diagnosis unit |
| 2 | notification device |
| SOC | state of charge |
| OCV | open circuit voltage |
| CCV | closed circuit voltage |
| R | charge resistance |
| $K_T$ | temperature conversion coefficient of resistance |
| SOHQ | state of health capacity |
| SOHR | state of health resistance |

**Claims**

1. A battery state diagnosis method for diagnosing a deterioration state of a secondary battery mounted on equipment, the battery state diagnosis method comprising:

   a data acquisition step of acquiring pieces of data about a voltage, a current, and a temperature of the secondary battery from the equipment in operation;
   a table creation step of creating, based on the acquired pieces of data, a table including a state of health capacity and a state of health resistance of the secondary battery; and
   a diagnosis step of diagnosing, using the created table, a deterioration state of the secondary battery.

2. The battery state diagnosis method according to claim 1, wherein
   the table creation step further includes creating:

   a table including a state of charge and an open circuit voltage of the secondary battery;
   a table including the state of charge and a charge resistance of the secondary battery; and
   a table including a temperature and a temperature conversion coefficient of a resistance of the secondary battery.

3. The battery state diagnosis method according to claim 1, wherein
   the table creation step includes creating the table using only data of the secondary battery in which a charging-start state of charge is less than or equal to a specific threshold.

4. The battery state diagnosis method according to claim 3, wherein
   as a specific threshold, within a range of a state of charge of 0 to 40%, a state of charge is set at which a change in an open circuit voltage with respect to the state of charge is smallest.

5. The battery state diagnosis method according to claim 1, wherein
   the table creation step includes creating the table using only data of the secondary battery in which a charging-end state of charge is greater than or equal to a specific threshold.

6. The battery state diagnosis method according to claim 5, wherein
   as a specific threshold, a state of charge of greater than or equal to 90% is used.

7. The battery state diagnosis method according to claim 5, wherein
   as a specific threshold, a charging voltage of greater than or equal to 3.5 V is used.

8. A battery diagnosis device for diagnosing a deterioration state of a secondary battery mounted on equipment, the battery diagnosis device comprising:

    a reception unit that acquires pieces of data about a voltage, a current, and a temperature of the secondary battery from the equipment in operation;
    a computation unit that creates, based on the acquired pieces of data, a table including a state of health capacity and a state of health resistance of the secondary battery; and
    a diagnosis unit that diagnoses, using the created table, a deterioration state of the secondary battery.

9. A battery diagnosis system comprising:

    the battery diagnosis device according to claim 8; and
    a notification device that notifies a customer of a deterioration state of a secondary battery diagnosed by the battery diagnosis device.

# FIG. 1

BATTERY DIAGNOSIS SYSTEM 100

# FIG. 2

D1

| No. | ITEM | VALUE | VALUE | VALUE |
|---|---|---|---|---|
| 1 | VEHICLE ID | 1234 | 1234 | 1234 |
| 2 | TIME | 2023/1/1 12:10:20 | 2023/1/1 12:10:25 | 2023/1/1 12:10:30 |
| 3 | VEHICLE STATE FLAG | CHARGING | CHARGING | CHARGING |
| 4 | PACK CURRENT A (CHARGING+, DISCHARGING−) | 10 | 10 | 10 |
| 5 | SOC [%] | 30 | 31 | 32 |
| 6 | NUMBER N OF SERIES-CONNECTED CELLS IN PACK | 100 | 100 | 100 |
| 7 | NUMBER M OF TEMPERATURE SENSORS IN PACK | 10 | 10 | 10 |
| 8 | BATTERY PACK INITIAL Ah CAPACITY | 40 | 40 | 40 |
| 9 | BATTERY PACK INITIAL Wh CAPACITY | 30 | 30 | 30 |
| 10 | FIRST BATTERY VOLTAGE [V] | 3.1 | 3.12 | 3.14 |
| : | : | : | : | : |
| 109 | 100TH BATTERY VOLTAGE [V] | 3.12 | 3.14 | 3.16 |
| 110 | FIRST TEMPERATURE SENSOR TEMPERATURE [°C] | 25 | 25 | 25 |
| : | : | : | : | : |
| 119 | 10TH TEMPERATURE SENSOR TEMPERATURE [°C] | 25.5 | 25.5 | 25.5 |

# FIG. 3A

T1

| STATE-OF-CHARGE SOC [%] | OPEN CIRCUIT VOLTAGE OCV [V] |
|---|---|
| 0 | 3.150 |
| 2 | 3.212 |
| . | . |
| . | . |
| 98 | 3.410 |
| 100 | 3.458 |

# FIG. 3B

T2

| STATE-OF-CHARGE SOC [%] | C RATE 0.1CA CHARGE RESISTANCE R [mΩ] | C RATE 0.3CA CHARGE RESISTANCE R [mΩ] | . CHARGE RESISTANCE R [mΩ] | . CHARGE RESISTANCE R [mΩ] |
|---|---|---|---|---|
| 0 | 2.158 | 1.988 | . | . |
| 2 | 2.001 | 1.912 | . | . |
| . | . | . | . | . |
| . | . | . | . | . |
| 98 | 3.410 | 2.923 | . | . |
| 100 | 5.412 | 4.953 | . | . |

# FIG. 3C

T3

| TEMPERATURE [°C] | $K_T[T]$ |
|---|---|
| −30 | 4.812 |
| −25 | 4.104 |
| . | . |
| 25 | 1.000 |
| . | . |
| 40 | 0.822 |

# FIG. 3D

T4

| STATE OF HEALTH CAPACITY SOHQ [%] | STATE OF HEALTH RESISTANCE SOHR [%] |
|---|---|
| 0 | 303.2 |
| 2 | 301.5 |
| . | . |
| . | . |
| 98 | 101.8 |
| 100 | 100 |

# FIG. 4

```
        ┌─────────────────────────────┐
        │            START            │
        └─────────────────────────────┘
                       │
                       ▼
        ┌─────────────────────────────┐
        │      READ VEHICLE DATA       │~~ S41
        └─────────────────────────────┘
                       │
                       ▼
        ┌─────────────────────────────┐
        │      EXTRACT PIECES OF DATA  │~~ S42
        │     ABOUT SOC AND VOLTAGES   │
        └─────────────────────────────┘
                       │
                       ▼
        ┌─────────────────────────────┐
        │        REMOVE OUTLIER        │~~ S43
        └─────────────────────────────┘
                       │
                       ▼
        ┌─────────────────────────────┐
        │    CALCULATE OPEN CIRCUIT    │~~ S44
        │     VOLTAGE AT EACH SOC      │
        └─────────────────────────────┘
                       │
                       ▼
        ┌─────────────────────────────┐
        │             END             │
        └─────────────────────────────┘
```

# FIG. 5

```
        ┌─────────────────────────────┐
        │            START            │
        └─────────────────────────────┘
                      │
                      ▼
        ┌─────────────────────────────┐
        │      READ VEHICLE DATA       │ ⟿ S51
        └─────────────────────────────┘
                      │
                      ▼
        ┌─────────────────────────────┐
        │    EXTRACT PIECES OF DATA    │
        │  ABOUT CURRENT, VOLTAGE,     │ ⟿ S52
        │     AND TEMPERATURE          │
        │      DURING CHARGING         │
        └─────────────────────────────┘
                      │
                      ▼
        ┌─────────────────────────────┐
        │        REMOVE OUTLIER        │ ⟿ S53
        └─────────────────────────────┘
                      │
                      ▼
        ┌─────────────────────────────┐
        │     CALCULATE RESISTANCE     │ ⟿ S54
        └─────────────────────────────┘
                      │
                      ▼
        ┌─────────────────────────────┐
        │   CALCULATE RESISTANCE AT    │
        │      EACH CURRENT AND        │ ⟿ S55
        │  TEMPERATURE SENSITIVITY     │
        │        COEFFICIENT           │
        └─────────────────────────────┘
                      │
                      ▼
        ┌─────────────────────────────┐
        │            END              │
        └─────────────────────────────┘
```

## FIG. 6

```
                    START

                       │
                       ▼
        ┌─────────────────────────────┐
        │      READ VEHICLE DATA       │  ～ S61
        └─────────────────────────────┘
                       │
                       ▼
        ┌─────────────────────────────┐
        │   EXTRACT CURRENT, VOLTAGE,  │  ～ S62
        │     TEMPERATURE, AND DATA    │
        │        DURING CHARGING       │
        └─────────────────────────────┘
                       │
                       ▼
        ┌─────────────────────────────┐
        │        REMOVE OUTLIER        │  ～ S63
        └─────────────────────────────┘
                       │
                       ▼
        ┌─────────────────────────────┐
        │      CALCULATE STATE OF      │  ～ S64
        │       HEALTH CAPACITY        │
        └─────────────────────────────┘
                       │
                       ▼
        ┌─────────────────────────────┐
        │  CALCULATE STATE OF HEALTH   │  ～ S65
        │  RESISTANCE AT EACH CAPACITY │
        │       RETENTION RATE         │
        └─────────────────────────────┘
                       │
                       ▼
                     END
```

# FIG. 7

```
          ┌─────────────────────────┐
          │          START          │
          └─────────────────────────┘
                       │
                       ▼
          ┌─────────────────────────┐
          │    READ VEHICLE DATA     │  ～ S71
          └─────────────────────────┘
                       │
                       ▼
          ┌─────────────────────────┐
          │  EXTRACT CURRENT, VOLTAGE,│
          │   TEMPERATURE, AND DATA   │  ～ S72
          │      DURING CHARGING      │
          └─────────────────────────┘
                       │
                       ▼
          ┌─────────────────────────┐
          │      REMOVE OUTLIER       │  ～ S73
          └─────────────────────────┘
                       │
                       ▼
          ┌─────────────────────────┐
          │   READ PARAMETER GROUP    │  ～ S74
          └─────────────────────────┘
                       │
                       ▼
          ┌─────────────────────────┐
          │ SOLVE SIMULTANEOUS EQUA-  │
          │ TIONS OF [FORMULAS 1 TO 4]│
          │ TO CALCULATE CHARGE START │  ～ S75
          │ SOC, CHARGE END SOC, STATE│
          │ OF HEALTH RESISTANCE, AND │
          │ STATE OF HEALTH CAPACITY  │
          └─────────────────────────┘
                       │
                       ▼
          ┌─────────────────────────┐
          │           END            │
          └─────────────────────────┘
```

## INTERNATIONAL SEARCH REPORT

| International application No. |
| --- |
| **PCT/JP2024/006941** |

| A. | CLASSIFICATION OF SUBJECT MATTER |
| --- | --- |

*G01R 31/392*(2019.01)i; *G01R 31/367*(2019.01)i; *G01R 31/389*(2019.01)i; *H01M 10/42*(2006.01)i; *H01M 10/48*(2006.01)i; *H02J 7/00*(2006.01)i
FI:   G01R31/392; G01R31/367; G01R31/389; H01M10/42 P; H01M10/48 P; H01M10/48 301; H02J7/00 Q

According to International Patent Classification (IPC) or to both national classification and IPC

| B. | FIELDS SEARCHED |
| --- | --- |

Minimum documentation searched (classification system followed by classification symbols)
   G01R31/36-31/396; H01M10/42-10/48; H02J7/00

Documentation searched other than minimum documentation to the extent that such documents are included in the fields searched

   Published examined utility model applications of Japan 1922-1996
   Published unexamined utility model applications of Japan 1971-2024
   Registered utility model specifications of Japan 1996-2024
   Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | WO 2021/049134 A1 (HITACHI, LTD.) 18 March 2021 (2021-03-18) paragraphs [0012]-[0048], fig. 1-7B | 1, 8-9 |
| A | | 2-7 |
| Y | WO 2018/179852 A1 (HITACHI AUTOMOTIVE SYSTEMS, LTD.) 04 October 2018 (2018-10-04) paragraphs [0012]-[0030], fig. 1-4 | 1, 8-9 |
| A | WO 2020/218184 A1 (GS YUASA INTERNATIONAL LTD.) 29 October 2020 (2020-10-29) paragraphs [0120]-[0129], fig. 23-25 | 1-9 |
| A | JP 2015-121520 A (KABUSHIKI KAISHA TOSHIBA) 02 July 2015 (2015-07-02) paragraphs [0099]-[0108], fig. 11-14 | 1-9 |
| E, A | WO 2024/048033 A1 (HITACHI HIGH-TECH CORPORATION) 07 March 2024 (2024-03-07) entire text | 1-9 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 April 2024** | **07 May 2024** |

| Name and mailing address of the ISA/JP | Authorized officer |
| --- | --- |
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT
### Information on patent family members

| International application No. |
| --- |
| **PCT/JP2024/006941** |

| Patent document cited in search report | | | Publication date (day/month/year) | Patent family member(s) | | | Publication date (day/month/year) |
| --- | --- | --- | --- | --- | --- | --- | --- |
| WO | 2021/049134 | A1 | 18 March 2021 | JP | 2021-44145 | A | |
| WO | 2018/179852 | A1 | 04 October 2018 | EP | 3605123 | A1 | |
| | | | | paragraphs [0012]-[0028], fig. 1-4 | | | |
| | | | | CN | 110446938 | A | |
| | | | | JP | 2018-169284 | A | |
| WO | 2020/218184 | A1 | 29 October 2020 | US | 2022/0179010 | A1 | |
| | | | | paragraphs [0160]-[0169], fig. 23-25 | | | |
| | | | | DE | 112020002141 | T5 | |
| | | | | CN | 113826260 | A | |
| | | | | JP | 2020-180935 | A | |
| JP | 2015-121520 | A | 02 July 2015 | (Family: none) | | | |
| WO | 2024/048033 | A1 | 07 March 2024 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2022024885 A1

**Non-patent literature cited in the description**

• **HIROSHI TAKEUCHI et al.** Statistics Dictionary. Toyo Keizai Inc.

• **G. K. KANJI**. Reverse Statistics. Kodansha, 20 August 2015